# EUROPEAN PATENT SPECIFICATION

(11) **EP 3 824 548 B1**
(45) Date of publication and mention of the grant of the patent: **21.10.2026**
(21) Application number: 19745654.4
(22) Date of filing: 17.07.2019
(51) Int. Cl.: H03F 1/02, H03F 1/22, H03F 3/21, H03F 3/72

(54) **ACTIVE NOISE SOURCE DESIGN**
ENTWURF EINER AKTIVEN GERÄUSCHQUELLE
CONCEPTION DE SOURCE DE BRUIT ACTIVE

(30) Priority: 18.07.2018 FI 20180085
(43) Date of publication of application: 26.05.2021
(73) Proprietor: Teknologian tutkimuskeskus VTT Oy, 02150 Espoo (FI)
(72) Inventor: VARONEN, Mikko, 02044 VTT (FI); FORSTEN, Henrik, 02044 VTT (FI); SAIJETS, Jan, 02044 VTT (FI)
(74) Representative: Kolster Oy Ab
(86) International application number: PCT/FI2019/050549
(87) International publication number: WO 2020/016483

(56) References cited:
- EP-A2- 0 742 602
- WO-A1-98/27644
- US-A1- 2011 187 585

## Description

### FIELD OF THE INVENTION

The invention relates to active noise sources, and particularly to active noise sources of broadband microwave and millimeter-wave noise.

### BACKGROUND OF THE INVENTION

Active noise sources are commonly used are used to test signals for measuring noise figure, frequency response, and other parameters, as well as for calibration purposes. A broadband noise from an active noise source is applied or injected to the device under test or calibration. A measurement is made with the noise source on; another measurement with the noise source off. From those measurements and the characteristics of the noise source, the noise figure can be calculated. Some methods require two sources: a "hot" and "cold" source.

Used for remote sensing in various applications and environments, microwave and millimeter-wave radiometers require frequent calibration. Microwave radiometers measure noise temperature using a suitable antenna which is designed to match a scene of interest. To calibrate the radiometer, calibration temperature level can be produced by a known noise source and injected into the radiometer input.

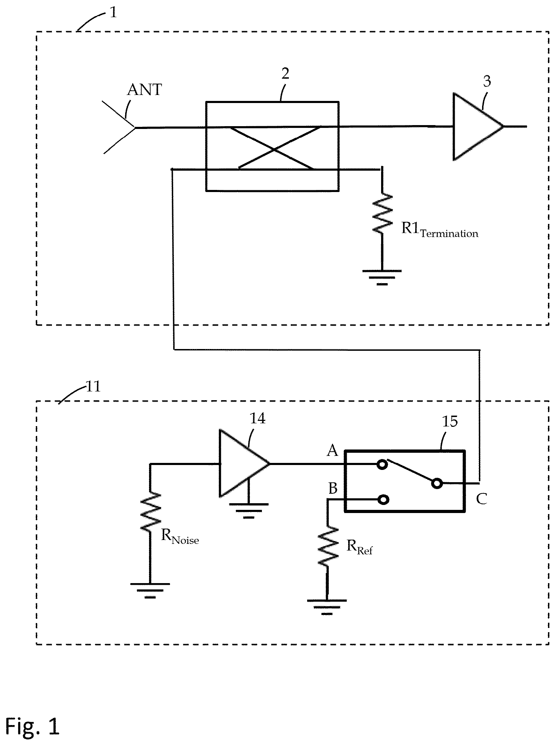

C. R. Parashare et al. "Noise sources for internal calibration of millimeter-wave radiometers", 13th Specialist Meeting on Microwave Radiometry and Remote Sensing of the Environment (MicroRad), 2014, pages 157 - 160, disclose two types of active noise sources for an internal calibration of a radiometer. The first type of noise sources consists of noise diodes and a Dicke switch as internal calibration sources. Dicke switch is used to alternately view two stable sources of known temperatures, most commonly noise diode signal coupled into the system and a 50 Ω reference load (matched termination) held at ambient temperature. The output of the Dicke switch is connected to an input of a low noise amplifier LNAs. The second type of noise source 11 is based on a low noise amplifier (LNA) 14, as shown in Figure 1. The input of the LNA 14 is terminated with a reference load or noise resistor R_{Noise} at ambient temperature. The LNA 14 amplifies the noise from the reference load R_{Noise}. An SPDT PIN-diode switch 15 is used to switch the amplified noise at node A (a hot noise source) or a reference load R_{Ref} at node B (a cold noise source) to the output C of the noise source 11, i.e. turn to the noise source 11 between ON and OFF states. The noise source 11 is ON, when the switch 15 is in state A-C (the output of the amplifier 14 is switched to the output C). The noise source 11 is OFF, when the switch 15 is in state B-C (the reference load R_{Ref} is switched to the output C). In Parashare et al, which is related to the calibration of a radiometer, the noise signal at the output of the noise source 11 is injected to an input of an amplifier 3 in the radiometer 1 via a directional coupler 2). Other ports of the directional coupler 2 are connected to an antenna and to a termination load R1_{Termination}. A disadvantage of the prior art noise source design that the noise bandwidth limited by the SPDT switch 15 and the matching between the noise amplifier 14 and switch 15. It is also very challenging to get a well-defined cold noise source with this prior art noise source design.

WO 98/27644 discloses a radiometer calibration system utilizing a microwave active noise source. The noise source is based on a noise equivalent model that is a micro-wave active circuit designed to simulate noise temperatures such as hot and cold thermal radiation temperatures when DC bias is applied.

### BRIEF DESCRIPTION OF THE INVENTION

An aspect of the present invention is a new active noise source design having a broader noise bandwidth.

An aspect of the present invention is an active noise source apparatus according to the independent claim. The preferred embodiments are disclosed in the dependent claims.

An aspect of the invention is an active noise source apparatus, comprising
a first switched-biased noise amplifier branch comprising a first noise amplifier having a switched biasing, and a first noise-generating device connected to supply a first noise signal to an input of the first noise amplifier,
a second switched-biased noise amplifier branch comprising a second

a noise amplifier having a switched biasing, and a second noise-generating device connected to supply a second noise signal to the input of the second noise amplifier, wherein the switched biasing of the first and second noise amplifiers is configured to switch the first and second noise amplifiers between an on-biased state and an off-biased state, and
a directional coupler having a pair of input ports connected to combine noise outputs from the first and second switched-biased noise amplifiers, one output port of the directional coupler being connected to a matched termination and another output port of the directional coupler being connected to supply an amplified noise signal to an output of the active noise source apparatus.

In an embodiment, the switched biasing of the first noise amplifier and the second noise amplifier being at least loosely synchronized with each other.

In an embodiment, the first noise amplifier and the second noise amplifier have essentially same structure and operation.

In an embodiment, the first noise-generating device and the second noise-generating device each comprises a resistor or a semiconductor device.

In an embodiment, the directional coupler comprises a 4-port directional coupler having a first input port connected to the output of the first noise amplifier, a second input port connected to the output of the second noise amplifier, a first output port connected to the output of the active noise source apparatus, and a second output port connected to the matched termination.

In an embodiment, the directional coupler comprises a Lange coupler having an input port, an isolated port, a direct port, and a coupled port.

In an embodiment, the output of the active noise source apparatus comprises a ground-signal-ground, GSG, contact pad.

In an embodiment, the output of the active noise source apparatus comprises a contact pad with a floating shield structure.

In an embodiment, the apparatus optionally comprises a galvanically interconnected first pair of a first ground pad and a respective separated parallel first ground metallization provided adjacent to the signal pad on one side, and a galvanically interconnected second pair of a second ground pad and a respective separated parallel ground metallization is provided adjacent to the signal pad on opposite side, wherein the first ground pad, the signal pad and the second ground pad are preferably substantially coplanar, and wherein the first ground metallization and the second ground metallization are galvanically interconnected and preferably substantially coplanar with the floating shield.

In an embodiment, a shunt transmission line is connected parallel with a capacitance of the GSG contact pad.

In an embodiment, the apparatus comprises means for monitoring a noise power at the matched termination.

In an embodiment, the apparatus comprises a noise power control arranged to adjust amplification of the first and second switched-biased noise amplifiers based on a noise power level monitored at the matched termination.

In an embodiment, the apparatus comprises a bias control arranged to adjust the switched biasing of the first and second noise amplifiers based on a noise power level monitored at the fourth output port connected to the matched termination.

Another aspect of the invention is a calibration arrangement of a radiometer, the calibration comprising the active noise source apparatus according the first aspect and its embodiments arranged to output a broadband noise signal that is injected to an input of the radiometer.

### BRIEF DESCRIPTION OF THE DRAWINGS

In the following the invention will be described in greater detail by means of exemplary embodiments with reference to the attached drawings, in which
Figure 1 is a schematic diagram illustrating a prior art active noise source connected to a receiver branch of a radiometer;
Figure 2 is a schematic diagram illustrating an active noise source according to an exemplary embodiment;
Figure 3 is a schematic diagram illustrating a noise amplifier with a switched biasing according to an exemplary embodiment;
Figure 4 is a schematic top view of an exemplary Lange coupler;
Figure 5 is a graph illustrating a return loss S11 spectrum and an ENR spectrum of an active noise source according to an exemplary embodiment; and
Figure 6 shows a perspective view of an exemplary shield structure of a GSG pad.

### DETAILED DESCRIPTION OF EXAMPLE EMBODIMENTS

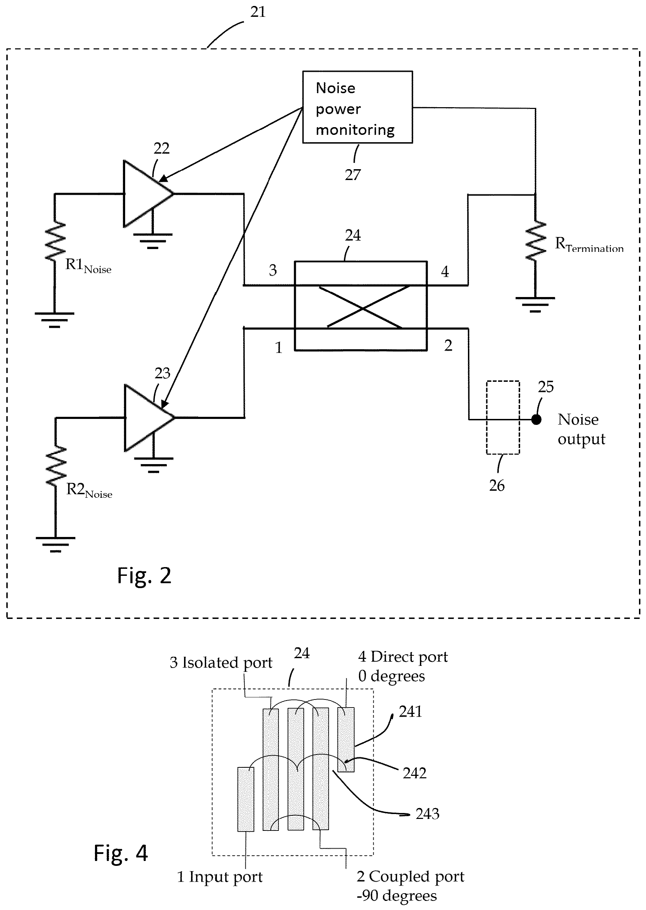

Figure 2 schematically illustrates an active noise source 21 according to an exemplary embodiment of the invention. The exemplary active noise source 21 comprises a pair of a first and second switched-biased noise amplifier branches with their noise outputs combined with a directional coupler 24, one port of the directional coupler being connected to a matched termination R_{Termination} and another port of the directional coupler 24 being connected to an output 25 of the active noise source 21. The switched biasing of the first noise amplifier branch and the second noise amplifier branch may be at least loosely synchronized with each other.

In the example illustrated in Figure 2, the first switched-biased noise amplifier branch comprises a first noise amplifier 22 having a switched biasing, and a first noise-generating device R1_{Noise} connected to the input of the first noise amplifier 22. The second switched-biased noise amplifier branch comprises a second noise amplifier 23 having a switched biasing, and a first noise-generating device R2_{Noise} connected to the input of the second noise amplifier 23. In the illustrated example the first and second noise-generating devices are implemented by a resistor R1_{Noise} and a resistor R2_{Noise}, respectively. A resistor at a certain temperature has a thermal noise associated with it, and the thermal noise is amplified by the amplifiers 22 and 23. The noise resistors R1_{Noise} and a resistor R2_{Noise} may be temperature-controlled resistors, for example enclosed within a constant-temperature housing. However, also other types of noise-generating devices may be used instead, such as noise diodes.

In exemplary embodiments, the two noise amplifiers may have same structure and same performance.

Each of the switched-biased noise amplifier branches 22 and 23 may be configured to separately produce broadband microwave and millimeter-wave noise, preferably broadband noise at frequencies higher than 100 GHz, more preferably within a frequency band from approximately 100 GHz to approximately 250 GHz.

The first and second noise amplifiers 22 and 23 are configured have a switched biasing, so that the each noise amplifier branch is switched between two operational states, cold and hot. The cold state is an off-biased state of the noise amplifier and the output is thermal noise generated by the off-biased noise amplifier. The hot state is an on-biased state of the noise amplifier and the output is the thermal noise generated by the noise resistor R1_{Noise} or R2_{Noise} and amplified by the on-biased noise amplifier 22 or 23, respectively. The noise amplifier branch in the hot state provides a known amount of noise in excess of the cold state noise. The excess noise is expressed as an Excess Noise Ratio, or ENR, and is related to the noise power or noise temperature above the cold state noise by $ENR = \frac{{T}_{Hot} - {T}_{Cold}}{{T}_{0}}$ where THot is a noise temperature in the hot state and the TCold is a noise temperature when the noise source is in the cold state. ENR normally is given as a logarithmic ratio in dB, or ${ENR}_{dB} = 10 ⋅ log \left(\frac{{T}_{Hot} - {T}_{Cold}}{{T}_{0}}\right)$

In embodiments, the active noise source 21 may have a temperature compensated. For example, a bias current may be temperature compensated.

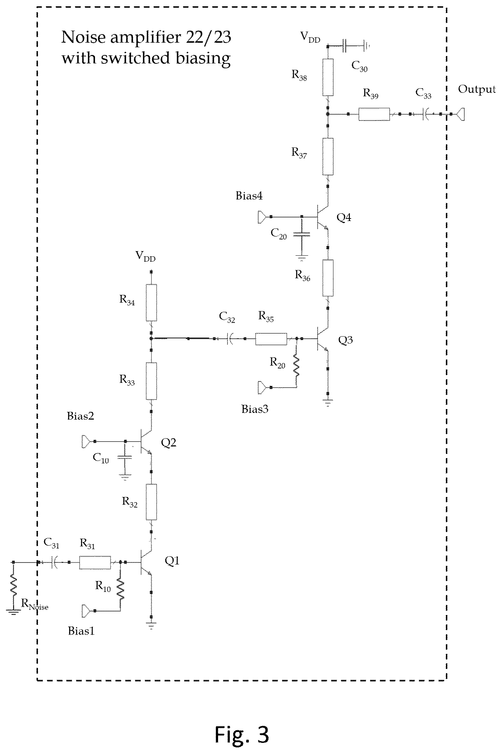

In an embodiment, each of the noise amplifiers 22 and 23 may be implemented as a two-stage cascode amplifier. A higher amplification or gain can be achieved by a cascode amplifier. An accurate cold noise state can be enabled by biasing off the second stage of the cascode amplifier. The first stage may be continuously biased on. An exemplary two-stage cascode amplifier is schematically illustrated in Figure 3. The first stage of the cascode amplifier 22 or 23 comprises a series connection of transmission-lines R34, R33 and R32, as well as transistors Q2 and Q1 between the supply voltage VDD (with a shunt capacitor C30) and the ground. The transistors Q1 and Q2 are biased with bias voltages Bias1 (via a resistor R10) and Bias2 (with a shunt capacitor C10), respectively. The noise resistor RNoise is connected to the base of the transistor Q1 via a coupling capacitor C31 and a transmission-line R31. The second stage of the cascode amplifier 22 or 23 comprises a series connection of transmission-lines R36, R37 and R38, as well as transistors Q4 and Q3 between the supply voltage VDD and the ground. The transistors Q3 and Q4 are biased with bias voltages Bias3 (via a resistor R20) and Bias4 (with a shunt capacitor C20), respectively. The noise signal from the collector circuit of the first stage is connected to the base of the transistor Q3 via a coupling capacitor C32 and a transmission-line R35. The noise signal from the collector circuit of the second stage is connected to output of the cascode amplifier via series transmission-line R39 and a coupling capacitor C32. The cold noise state can be enabled by controlling one or more of the bias voltages Bias3 and Bias4 in the second stage of the cascade amplifier to bias the transistors Q3 and Q4 to off-state. In the hot noise state, the bias voltages Bias1 and Bias3 may be equal and the bias voltages Bias2 and Bias4 may be equal respectively. The levels of the bias voltages may be controlled based on a monitored output noise power of the active noise source. The amplifiers 22 and 23 may be implemented with IHP G2 SiGe HBT technology, for example.

The noise amplifier branches may biased to the hot state and the cold state in the same time, or at least in loose synchronism, so that the noise power levels from the noise amplifier branches, as well as the output impedances, are substantially equal at any moment of time.

The outputs from the noise amplifier branches are connected to respective ports of the directional coupler 24. The noise outputs of the amplifier branches are summed and combined by the directional coupler 24. Directional couplers typically have four ports. The coupler is usually designed for 3 db of coupling between the "input port" 1 and the coupled and direct (through) ports 2 and 4, respectively. One of the benefits of the directional coupler 24 is the outputs of the individual amplifiers 22 and 23 may have a poor impedance match that, however, is not seen at the output port of the directional coupler 4. The noise signal signals reflected at the outputs of the amplifiers 22 and 23 are dissipated in the matched termination resistor R_{Termination} at the direct output 4. Typically, the matched termination resistor R_{Termination} may be a 50 ohms resistor. As a result, the coupled port 2 of the directional coupler 24, and thereby the output of the active noise source 21 is matched to 50 ohms and is completely isolated from the reflected signals.

In embodiments, the directional coupler is a 90 degrees or quadrature hybrid coupler there is a 90 degrees phase shift between the direct port 4 and the coupled port 2. The phase shift is not relevant to the broadband noise signals.

In exemplary embodiments, the directional coupler 24 may be implemented as a Lange coupler. The Lange coupler is a four port interdigitated structure wherein the coupling is derived from closely spaced transmission lines, such as microstrip lines. For a given input on a Lange coupler the three output ports can be denoted as: an isolated port, a direct (through) port, and a coupled port (-90 degree transmission angle compared to the direct port). An example geometry for a Lange coupler 24 having four conductors or fingers 240 is shown in Figure 4. The conductors or fingers 241 may be separated by spaces 243 and connected by bonding wires 242 as illustrated.

In embodiments, the noise power at the matched termination resistor R_{Termination} may be monitored or measured, as illustrated by the noise power monitoring unit 27 in Figure 2. There may be a feedback loop to control the amplification of the noise amplifier branches based on the monitored output noise power to maintain a desired noise power level. For example, the biasing of the noise amplifiers 22 and 23 may be controlled based on the monitored output noise power.

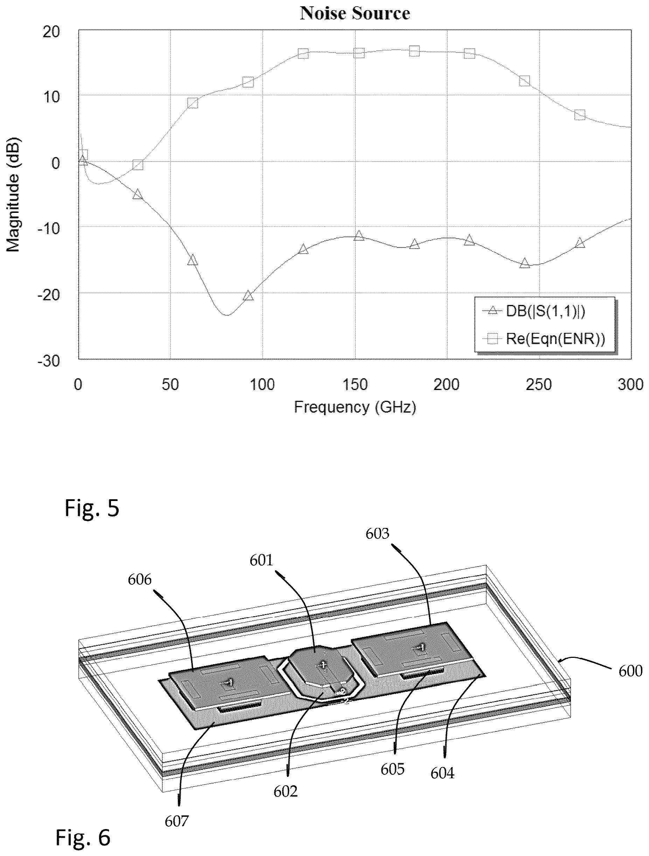

Embodiments of the invention enable an active noise source having improved output matching and wideband operation with a flat ENR or noise temperature characteristic. Figure 5 shows simulation results for an exemplary active noise source according to the present invention. The simulated noise source designed to have a flat output noise power in the frequency band 140 - 220 GHz. As shown in Figure 5, the design goal was achieved very well. The ENR curve is very flat or constant in the desired frequency band. Also the noise source output matching is very good, the return loss S11 being rather flat and less than -10 db in the desired frequency band.

In a circuit implementation, a wiring pad for connecting the output 25 of the active noise source 21 to an external circutry may cause impedance mismatch that may be taken into consideration. For example a floating ground shield parallel with the wiring pad may be used to compensate the inherent pad capacitance. A ground-signal-ground (GSG) pad optimised for a minimum capasitance may be used at the output 25. For example, the pad capacitance may be reduced by a floating shield structure. An example of a GSG pad with a floating shield structure is illustrated in Figure 6. A housing of an active noise source is generally presented by a block 600 wherein the GSG pad is shown exposed. An RF signal pad 601 is provided with a floating shield 602 to reduce the pad capacitance. A pair of an RF ground pad 603 and a separated parallel MMIC ground metallization 604 galvanically interconnected by a wiring 605 is provided adjacent to the signal pad 601 on side. A corresponding pair of an RF ground pad 606 and a separated parallel MMIC ground metallization 607 galvanically interconnected by a wiring is provided adjacent to the signal pad 601 on opposite side. The RF ground pad 603, the RF signal pad and the RF ground pad 603 are preferably substantially coplanar, i.e. extend in the same first plane, and the MMIC ground metallization 604 and the MMIC ground metallization 607 are galvanically interconnected and preferably substantially coplanar with the floating shield 602, i.e. extend in the same second plane, wherein the first plane is substantialy parallel to but spaced apart from the second plane. As a further example, the pad capacitance may be matched with a shunt transmission line. Such optional arrangements are generally represented by a block 26 in Figure 2.

The invention and its embodiments are not limited to the examples described above but may vary within the scope of the claims.

## Claims

1. An active noise source apparatus, **characterized in that** the apparatus comprises
a first switched-biased noise amplifier branch (22) comprising a first noise amplifier (22) having a switched biasing, and a first noise-generating device (R1_{Noise}) connected to supply a first noise signal to an input of the first noise amplifier (22),
a second switched-biased noise amplifier branch (23) comprising a second noise amplifier (23) having a switched biasing, and a second noise-generating device (R2_{Noise}) connected to supply a second noise signal to the input of the second noise amplifier (23), wherein the switched biasing of the first and second noise amplifiers (22, 23) is configured to switch the first and second noise amplifiers between an on-biased state and an off-biased state, and
a directional coupler (24) having a pair of input ports (1,3) connected to combine noise outputs from the first and second switched-biased noise amplifier branches (22, 23), one output port (4) of the directional coupler (24) being connected to a matched termination (R_{Termination}) and another output port (2) of the directional coupler (24) being connected to supply an amplified noise signal to an output (25) of the active noise source apparatus (21).

2. The apparatus as claimed in any one of preceding claims, wherein the switched biasing of the first noise amplifier (22) and the second noise amplifier (23) being at least loosely synchronized with each other.

3. The apparatus as claimed in any one of preceding claims, wherein the first noise amplifier (22) and the second noise amplifier (23) have essentially same structure and operation.

4. The apparatus as claimed in any one of preceding claims, wherein the first noise-generating device (R1_{Noise}) and the second noise-generating device (R2_{Noise}) each comprises a resistor or a semiconductor device

5. The apparatus as claimed in any one of preceding claims, wherein the directional coupler comprises a 4-port directional coupler (24) having a first input port (3) connected to the output of the first noise amplifier (22), a second input port (1) connected to the output of the second noise amplifier (23), a first output port (2) connected to the output (25) of the active noise source apparatus (21), and a second output port (4) connected to the matched termination (R_{Termina-tion}).

6. The apparatus as claimed in any one of preceding claims, wherein the directional coupler comprises a Lange coupler (24) having an input port (1), an isolated port (3), a direct port (4), and a coupled port (2).

7. The apparatus as claimed in any one of preceding claims, wherein the output (25) of the active noise source apparatus (21) comprises a ground-signal-ground, GSG, contact pad (26).

8. The apparatus as claimed in any one of preceding claims, wherein the output (25) of the active noise source apparatus (21) comprises a contact pad (601) with a floating shield structure (602), and the apparatus optionally comprising a galvanically interconnected first pair of a first ground pad (603) and a respective separated parallel first ground metallization (604) provided adjacent to the signal pad (601) on one side, and a galvanically interconnected second pair of a second ground pad (606) and a respective separated parallel ground metallization (607) is provided adjacent to the signal pad (601) on opposite side, wherein the first ground pad (603), the signal pad (601) and the second ground pad (606) are preferably substantially coplanar, and wherein the first ground metallization (604) and the second ground metallization (607) are galvanically interconnected and preferably substantially coplanar with the floating shield (602).

9. The apparatus as claimed in any one of preceding claims, wherein a shunt transmission line is connected parallel with a capacitance of the GSG contact pad.

10. The apparatus as claimed in any one of preceding claims, comprising means (27) for monitoring a noise power at the matched termination.

11. The apparatus as claimed in any one of preceding claims, comprising a noise power control (27) arranged to adjust amplification of the first and second switched-biased noise amplifiers (22, 23) based on a noise power level monitored at the matched termination.

12. The apparatus as claimed in any one of preceding claims, comprising a bias control (27) arranged to adjust the switched biasing of the first and second noise amplifiers (22, 23) based on a noise power level monitored at the fourth output port (4) connected to the matched termination (R_{Termination}).

13. A calibration arrangement of a radiometer, the calibration comprising the active noise source apparatus as claimed in any one of claims 1-12 arranged to output a broadband noise signal that is injected to an input of the radiometer.

## Patentansprüche

1. Aktive Rauschquelleneinrichtung, **dadurch gekennzeichnet, dass** die Einrichtung Folgendes umfasst
einen ersten Rauschverstärkerzweig (22) mit geschalteter Vorspannung, der einen ersten Rauschverstärker (22), der eine geschaltete Vorspannung aufweist, und eine erste Rauscherzeugungsvorrichtung (R1_{Noise}), die dazu verbunden ist, ein erstes Rauschsignal an einen Eingang des ersten Rauschverstärkers (22) zuzuführen, umfasst,
einen zweiten Rauschverstärkerzweig (23) mit geschalteter Vorspannung, der einen zweiten Rauschverstärker (23), der eine geschaltete Vorspannung aufweist, und eine zweite Rauscherzeugungsvorrichtung (R2_{Noise}), die dazu verbunden ist, ein zweites Rauschsignal an den Eingang des zweiten Rauschverstärkers (23) zuzuführen, umfasst, wobei die geschaltete Vorspannung des ersten und des zweiten Rauschverstärkers (22, 23) dazu ausgebildet ist, den ersten und den zweiten Rauschverstärker zwischen einem Zustand mit eingeschalteter Vorspannung und einem Zustand mit ausgeschalteter Vorspannung zu schalten, und
einen Richtkoppler (24), der ein Paar von Eingangsanschlüssen (1, 3) aufweist, die dazu verbunden sind, Rauschausgänge von dem ersten und dem zweiten Rauschverstärkerzweig (22, 23) mit geschalteter Vorspannung zu kombinieren, wobei ein Ausgangsanschluss (4) des Richtkopplers (24) mit einem angepassten Abschlusswiderstand (R_{Termination}) verbunden ist und ein weiterer Ausgangsanschluss (2) des Richtkopplers (24) dazu verbunden ist, ein verstärktes Rauschsignal an einen Ausgang (25) der aktiven Rauschquelleneinrichtung (21) zuzuführen.

2. Einrichtung nach einem der vorstehenden Ansprüche, wobei die geschaltete Vorspannung des ersten Rauschverstärkers (22) und des zweiten Rauschverstärkers (23) mindestens locker miteinander synchronisiert sind.

3. Einrichtung nach einem der vorstehenden Ansprüche, wobei der erste Rauschverstärker (22) und der zweite Rauschverstärker (23) im Wesentlichen dieselbe Konstruktion und Funktionsweise aufweisen.

4. Einrichtung nach einem der vorstehenden Ansprüche, wobei die erste Rauscherzeugungsvorrichtung (R1_{Noise}) und die zweite Rauscherzeugungsvorrichtung (R2_{Noise}) jeweils einen Widerstand oder eine Halbleitervorrichtung umfassen.

5. Einrichtung nach einem der vorstehenden Ansprüche, wobei der Richtkoppler einen 4-Anschluss-Richtkoppler (24) umfasst, der einen ersten Eingangsanschluss (3), der mit dem Ausgang des ersten Rauschverstärkers (22) verbunden ist, einen zweiten Eingangsanschluss (1), der mit dem Ausgang des zweiten Rauschverstärkers (23) verbunden ist, einen ersten Ausgangsanschluss (2), der mit dem Ausgang (25) der aktiven Rauschquelleneinrichtung (21) verbunden ist, und einen zweiten Ausgangsanschluss (4), der mit dem angepassten Abschlusswiderstand (R_{Termination}) verbunden ist, aufweist.

6. Einrichtung nach einem der vorstehenden Ansprüche, wobei der Richtkoppler einen Lange-Koppler (24) umfasst, der einen Eingangsanschluss (1), einen isolierten Anschluss (3), einen Direktanschluss (4) und einen gekoppelten Anschluss (2) aufweist.

7. Einrichtung nach einem der vorstehenden Ansprüche, wobei der Ausgang (25) der aktiven Rauschquelleneinrichtung (21) ein Masse-Signal-Masse-, GSG-, Kontaktpad (26) umfasst.

8. Einrichtung nach einem der vorstehenden Ansprüche, wobei der Ausgang (25) der aktiven Rauschquelleneinrichtung (21) ein Kontaktpad (601) mit einer potentialfreien Abschirmkonstruktion (602) umfasst und die Einrichtung optional ein galvanisch miteinander verbundenes erstes Paar aus einem ersten Massepad (603) und einer jeweiligen getrennten, parallelen ersten Masse-Metallisierung (604), die auf einer Seite benachbart zu dem Signalpad (601) bereitgestellt ist, umfasst, und ein galvanisch miteinander verbundenes zweites Paar aus einem zweiten Massepad (606) und einer jeweiligen getrennten, parallelen Masse-Metallisierung (607) auf einer gegenüberliegenden Seite benachbart zu dem Signalpad (601) bereitgestellt ist, wobei das erste Massepad (603), das Signalpad (601) und das zweite Massepad (606) vorzugsweise im Wesentlichen koplanar sind und wobei die erste Masse-Metallisierung (604) und die zweite Masse-Metallisierung (607) galvanisch miteinander verbunden und vorzugsweise im Wesentlichen koplanar mit der potentialfreien Abschirmung (602) sind.

9. Einrichtung nach einem der vorstehenden Ansprüche, wobei eine Nebenschluss-Übertragungsleitung parallel zu einer Kapazität des GSG-Kontaktpads verbunden ist.

10. Einrichtung nach einem der vorstehenden Ansprüche, umfassend Mittel (27) zum Überwachen einer Rauschleistung an dem angepassten Abschlusswiderstand.

11. Einrichtung nach einem der vorstehenden Ansprüche, umfassend eine Rauschleistungssteuereinheit (27), die dazu eingerichtet ist, eine Verstärkung des ersten und des zweiten Rauschverstärkers (22, 23) mit geschalteter Vorspannung basierend auf einem an dem angepassten Abschlusswiderstand überwachten Rauschleistungspegel einzustellen.

12. Einrichtung nach einem der vorstehenden Ansprüche, umfassend eine Vorspannungssteuereinheit (27), die dazu eingerichtet ist, die geschaltete Vorspannung des ersten und des zweiten Rauschverstärkers (22, 23) basierend auf einem Rauschleistungspegel einzustellen, der an dem vierten Ausgangsanschluss (4) überwacht wird, der mit dem angepassten Abschlusswiderstand (R_{Termination}) verbunden ist.

13. Kalibrierungsanordnung eines Radiometers, wobei die Kalibrierung die aktive Rauschquelleneinrichtung nach einem der Ansprüche 1-12 umfasst, die dazu ausgebildet ist, ein breitbandiges Rauschsignal auszugeben, das in einen Eingang des Radiometers eingespeist wird.

## Revendications

1. Appareil de source de bruit active, **caractérisé en ce que** l'appareil comprend
une première branche d'amplificateur de bruit à polarisation commutée (22) comprenant un premier amplificateur de bruit (22) présentant une polarisation commutée, et un premier dispositif générateur de bruit (R1_{Noise}) connecté pour fournir un premier signal de bruit à une entrée du premier amplificateur de bruit (22),
une deuxième branche d'amplificateur de bruit à polarisation commutée (23) comprenant un deuxième amplificateur de bruit (23) présentant une polarisation commutée, et un deuxième dispositif générateur de bruit (R2_{Noise}) connecté pour fournir un deuxième signal de bruit à l'entrée du deuxième amplificateur de bruit (23), dans lequel la polarisation commutée des premier et deuxième amplificateurs de bruit (22, 23) est configurée pour commuter les premier et deuxième amplificateurs de bruit entre un état polarisé et un état non polarisé, et
un coupleur directionnel (24) présentant une paire de ports d'entrée (1,3) connectés pour combiner des sorties de bruit des première et deuxième branches d'amplificateur de bruit à polarisation commutée (22, 23), un port de sortie (4) du coupleur directionnel (24) étant connecté à une terminaison appariée (R_{Termination}) et un autre port de sortie (2) du coupleur directionnel (24) étant connecté pour fournir un signal de bruit amplifié à une sortie (25) de l'appareil de source de bruit active (21).

2. Appareil selon l'une quelconque des revendications précédentes, dans lequel les polarisations commutées du premier amplificateur de bruit (22) et du deuxième amplificateur de bruit (23) sont au moins synchronisées l'une avec l'autre de manière lâche.

3. Appareil selon l'une quelconque des revendications précédentes, dans lequel le premier amplificateur de bruit (22) et le deuxième amplificateur de bruit (23) présentent essentiellement la même structure et le même fonctionnement.

4. Appareil selon l'une quelconque des revendications précédentes, dans lequel le premier dispositif générateur de bruit (R1_{Noise}) et le deuxième dispositif générateur de bruit (R2_{Noise}) comprennent chacun une résistance ou un dispositif semiconducteur.

5. Appareil selon l'une quelconque des revendications précédentes, dans lequel le coupleur directionnel comprend un coupleur directionnel à 4 ports (24) présentant un premier port d'entrée (3) connecté à la sortie du premier amplificateur de bruit (22), un deuxième port d'entrée (1) connecté à la sortie du deuxième amplificateur de bruit (23), un premier port de sortie (2) connecté à la sortie (25) de l'appareil de source de bruit active (21), et un deuxième port de sortie (4) connecté à la terminaison appariée (R_{Termination}).

6. Appareil selon l'une quelconque des revendications précédentes, dans lequel le coupleur directionnel comprend un coupleur de Lange (24) présentant un port d'entrée (1), un port isolé (3), un port direct (4) et un port couplé (2).

7. Appareil selon l'une quelconque des revendications précédentes, dans lequel la sortie (25) de l'appareil de source de bruit active (21) comprend une pastille de contact masse-signal-masse, GSG, (26).

8. Appareil selon l'une quelconque des revendications précédentes, dans lequel la sortie (25) de l'appareil de source de bruit active (21) comprend une pastille de contact (601) avec une structure de blindage flottant (602), et l'appareil comprenant facultativement une première paire interconnectée galvaniquement d'une première pastille de terre (603) et d'une première métallisation de terre (604) parallèle séparée respective disposée adjacente à la pastille de signal (601) d'un côté, et une deuxième paire interconnectée galvaniquement d'une deuxième pastille de terre (606) et d'une métallisation de terre (607) parallèle séparée respective disposée adjacente à la pastille de signal (601) du côté opposé, dans lequel la première pastille de terre (603), la pastille de signal (601) et la deuxième pastille de terre (606) sont de préférence sensiblement coplanaires, et dans lequel la première métallisation de terre (604) et la deuxième métallisation de terre (607) sont galvaniquement interconnectées et préférablement sensiblement coplanaires avec le blindage flottant (602).

9. Appareil selon l'une quelconque des revendications précédentes, dans lequel une ligne de transmission de dérivation est connectée en parallèle à une capacitance de la pastille de contact GSG.

10. Appareil selon l'une quelconque des revendications précédentes, comprenant des moyens (27) de surveillance d'une puissance de bruit au niveau de la terminaison appariée.

11. Appareil selon l'une quelconque des revendications précédentes, comprenant une commande de puissance de bruit (27) agencée pour ajuster l'amplification des premier et deuxième amplificateurs de bruit à polarisation commutée (22, 23) sur la base d'un niveau de puissance de bruit surveillé au niveau de la terminaison appariée.

12. Appareil selon l'une quelconque des revendications précédentes, comprenant une commande de polarisation (27) agencée pour ajuster la polarisation commutée des premier et deuxième amplificateurs de bruit (22, 23) sur la base d'un niveau de puissance sonore surveillé au niveau du quatrième port (4) connecté à la terminaison appariée (R_{Termination}).

13. Agencement d'étalonnage d'un radiomètre, l'étalonnage comprenant l'appareil de source de bruit active selon l'une quelconque des revendications 1 à 12 agencé pour délivrer en sortie un signal de bruit à large bande qui est injecté dans une entrée du radiomètre.
